# EUROPEAN PATENT APPLICATION

(11) **EP 1 544 324 A1**
(43) Date of publication of application: **22.06.2005**
(21) Application number: 02760056.8
(22) Date of filing: 19.08.2002
(51) Int. Cl.: C23G 1/06

(54) **REMOVER SOLUTION**

(71) Applicant: Merk-Kanto Advanced Chemical Ltd., Taipei 105 (TW)
(72) Inventor: Li, Ying-Hao, Hsinchu 300 Taiwan (CN); Lu, Chih-Peng, Taipei Hsien 244 Taiwan (CN)
(74) Representative: Becker Kurig Straus
(86) International application number: PCT/CN2002/000574
(87) International publication number: WO 2004/016827

(57) **Abstract**

A cleaning (stripping) solution comprises a mixture of a first compound, a second compound and water. The cleaning solution can effectively remove metal oxides without damaging the surface of the metal materials. The cleaning solution can successfully remove both organic and inorganic residues.

## Description

### BACKGROUND OF THE INVENTION

### Field of Invention

The present invention relates to a cleaning solution used after removing resist. More particularly, the present invention relates to a cleaning solution effective for removing organic or inorganic residues after dry etching and resist removal in the manufacturing processes of semiconductor devices.

### Description of Related Art

Etching is one of the most important technologies in the manufacture of semiconductor devices. In general, the pattern of devices in the photomask is transferred to the photoresist layer by photolithography, and etching is then performed to transfer the pattern to the underlying material layer. Such patterned material layer becomes a part of the semiconductor device. Taking a MOS device or a CMOS device as an example, the patterned material layer can be a layer of silicon oxide (SiO2), silicon nitride (Si3N4), polysilicon, aluminum alloy or phosphosilicate (PSG), integrated in the device. That is, almost all the materials used in the semiconductor device have to be processed through film deposition, photolithography and etching, layer by layer during the manufacturing of the device.

For example, in the processes of forming wirings, a silicon oxide layer and a conductive layer (polysilicon or other metal materials, such as aluminum etc.) are formed sequentially on the substrate. After a patterned photoresist layer is formed on the conductive layer, dry etching is performed to the exposed conductive layer to form the wiring pattern by using the photoresist layer as mask. Afterwards, the photoresist layer is removed.

However, because the organic residues, such as, high molecular weight polymer, and inorganic residues, including metal oxide and metal oxide-high molecular weight compounds are formed at the same time after dry etching or after photoresist (resist) ashing, the conventional stripping liquids can not completely remove these two kinds of residues. Moreover, these two kinds of residues may seriously affect the following manufacture process or even damage the wafer.

In the conventional process of forming a dual damascene structure, a substrate having a copper wiring layer and a dielectric layer on the copper wiring layer is provided. The dielectric layer is made of a low-k dielectric material. After defining the damascene pattern by using the photomask, two etching processes are performed to form a dual damascene opening exposing a portion of the copper wiring layer.

Meanwhile, residues, including high molecular weight polymer and copper oxide-high molecular weight compounds, are formed on a surface of the exposed dielectric layer, along with copper oxide formed on the copper wiring layer.

For cleaning the aforementioned residues, the prior art usually applies a cleaning solution for removing the residues. The composition of the well-known cleaning solution, for example, as disclosed in US Patent No. 5,905,063 consists of 2% fluoric acid, 88% dimethylsulfoxide and 10% water, or as disclosed in US Patent No. 6,156,661 consists of 55% diglycolamine, 10% gallic acid, 30% hydroxylamine and 5% water. For the copper processes, the cleaning capabilities of these two cleaning solutions for copper oxide are not satisfactory.

In the prior art, a stripping liquid containing oxalic acid and water has been proposed. Although the proposed stripping liquid can effectively remove copper oxide, the stripping liquid corrodes the surface of copper wiring material.

Furthermore, as the line-width of the device keeps shrinking, it becomes more difficult for the stripping liquid to rinse the residues out after reaction, thus further degrading the cleaning efficiency of the prior cleaning solutions.

### SUMMARY OF THE INVENTION

Accordingly, one aspect of the present invention is to provide a cleaning solution effective for removing metal oxides.

Accordingly, another aspect of the present invention is to provide a cleaning solution effective for removing metal oxides without damaging the surface of the metal materials.

Accordingly, another aspect of the present invention is to provide a cleaning (stripping) solution effective for removing both organic and inorganic residues.

Accordingly, another aspect of the present invention is to provide a cleaning solution, which does not damage the low-k dielectric materials.

As embodied and broadly described herein, the present invention provides a cleaning solution, which is a mixture having a composition comprising a first compound, a second compound and water. The suitable first compound can be selected from the group consisting of oxalic acid, malonic acid, tartaric acid, propene-1,2,3-tricarboxylic acid, sulfosuccinic acid, oxalacetic acid, methylenesuccinic acid, succinic acid, citramalic acid and malic acid. The suitable second compound can be selected from the group consisting of citric acid, glyoxylic acid, lactic acid, mercaptosuccinic acid, fumaric acid, acetylenedicarboxylic acid and methacrylic acid.

Furthermore, an inhibitors or suppressor can be added to the cleaning solution, in order to minimize the erosive action of the cleaning solution toward the metal materials, such as copper etc.. The suitable suppressors can be selected from the group consisting of 1,2,3-benzotriazole, benzoinoxime, salicylasldoxime, bis [4-amino-5-hydroxy-1,2,3-triazol-3-yl] methane and bis [4-amino-5-hydroxy-1,2,4-triazol-3-yl] butane.

Alternatively, a surfactant can be added into the solution. The surfactant includes, for example, a nonyl phenol polyethylene glycol ether.

In addition, a water-soluble solvent can be further added into the cleaning (stripping) solution of the present invention. The suitable water-soluble solvent can be selected from the group consisting of γ-butyrolactone, N-methyl-2-pyrrolidone, propylene glycol methyl ether (PGME), dimethylsulfoxide (DMSO), teramethylenesulfone, 1,3-dimethyl-2-imidazolidinone, 1,3-diethyl-2-imidazolidinone, ethylene glycol, ethylene glycol monoethyl ether, ethylene glycol monobutyl ether, N,N-dimethylformamide and N,N-dimethylacetamide.

It is to be understood that both the foregoing general description and the following detailed description are exemplary, and are intended to provide further explanation of the invention as claimed.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

Fig. 1 is a diagram illustrating the removed thickness of copper oxide versus the reaction time using three cleaning solutions.

Fig. 2 is a picture showing a portion of a wafer with organic and inorganic residues on the surface.

Fig. 3 is a picture showing the wafer of Fig. 2 rinsed with the cleaning solution according to one preferred embodiment of this invention.

### DESCRIPTION OF THE PREFERRED EMBODIMENTS

The cleaning (stripping) solution of the present invention is a mixture having a composition comprising a first compound, a second compound and water.

The suitable first compound can be, but not limited to, oxalic acid, malonic acid, tartaric acid, propene-1,2,3-tricarboxylic acid, sulfosuccinic acid, oxalacetic acid, methylenesuccinic acid, succinic acid, citramalic acid or malic acid. Preferably, the first compound is malonic acid. The first compound in the mixture is mainly responsible for removing residues including metal oxide, high molecular weight compounds and metal oxide-high molecular weight compounds, because the first compound can effectively dissolve metal oxide (such as copper oxide), metal oxide-high molecular weight compounds and high molecular weight polymers.

For the cleaning (stripping) solution of the present invention, the first compound has a weight percentage of about 1% - 20%, preferably 2% -15%, most preferably 3% -8%. If the first compound has a weight percentage lower than 1% in the stripping solution, the capability of the stripping solution for removing metal oxides (such as copper oxide) is greatly reduced. However, if the first compound has a weight percentage higher than 20% in the stripping solution, the stripping solution may corrode the metal materials (such as copper).

The second compound in the cleaning solution of the present invention is responsible for suppressing the corrosive effect of the stripping solution toward the metal materials, such as copper etc.. In fact, because the second compound can partially dissolve the metal oxide (such as copper oxide), when co-existing with the first compound, the second compound can enhance the ability of the stripping solution for removing metal oxides, in addition to suppressing the corrosive effect of the first compound toward the metal materials. As a result, the second compound in the cleaning solution of the present invention can act as an auxiliary for mitigating the corrosive effect of the first compound toward the metal materials and for removing metal oxides.

The suitable second compound can be, but not limited to, citric acid, glyoxylic acid, lactic acid, mercaptosuccinic acid, fumaric acid, acetylenedicarboxylic acid or methacrylic acid. Preferably, the second compound is glyoxylic acid or methacrylic acid.

For the cleaning (stripping) solution of the present invention, the second compound has a weight percentage of about 0.01% - 20%, preferably 0.1% -10%, most preferably 0.15% -1.0%. If the second compound has a weight percentage higher than 20% in the stripping solution, the capability for suppressing the corrosive effect of the stripping solution is reduced.

Furthermore, an inhibitor or suppressor for preventing the metal materials from eroding by the cleaning (stripping) solution can be added, in order to minimize the erosive action of the stripping solution toward the metal materials, such as copper or aluminum.

The suitable suppressors can be, but not limited to, 1,2,3-benzotriazole, benzoinoxime, salicylasldoxime, bis [4-amino-5-hydroxy-1,2,3-triazol-3-yl] methane or bis [4-amino-5-hydroxy-1,2,4-triazol-3-yl] butane. Preferably, the suppressor is 1,2,3-benzotriazole.

Since the line-width of the device keeps shrinking, and in the prior art cleaning solution, the molecules in the solution remove the organic residues through binding with the organic residues and thus ion-complexes of larger particles, it becomes more difficult for the solution to wash the large particle ion-complexes away from the wafer surface in limited spaces. Hence, the removal effects of the organic residues are greatly reduced.

Although the cleaning solution of the present invention is effective for removing both organic and inorganic residues at the same time, a surfactant can be added into the solution for enhancing the removal efficacy of removing residues. By way of the emulsion effect of the surfactant, the large particle ion-complexes can easily dissolve in water, thus significantly promoting removal of the organic residues. The surfactant is, for example, a nonyl phenol polyethylene glycol ether.

A water-soluble solvent can be further added into the cleaning solution of the present invention for enhancing the efficacy of removing organic residues. Through the reaction of hydrophobic and hydrophilic groups in the water-soluble solvent, the surface tension of the ion-complexes can be reduced, so that the ion-complexes can easily diffuse out and then rinsed away by water.

The suitable water-soluble solvent can be, but not limited to, a water-soluble solution of γ-butyrolactone, N-methyl-2-pyrrolidone, propylene glycol methyl ether (PGME), dimethylsulfoxide (DMSO), teramethylenesulfone, 1,3-dimethyl-2-imidazolidinone, 1,3-diethyl-imidazolidinone, ethylene glycol, ethylene glycol monoethyl ether, ethylene glycol monobutyl ether, N,N-dimethylformamide or N,N-dimethylacetamide, a hydrophilic solvent or water. Preferably, the water-soluble solvent is a water-soluble solution of propylene glycol methyl ether (PGME), dimethylsulfoxide (DMSO) or γ-butyrolactone.

For the cleaning solution of the present invention, the water-soluble solvent has a weight percentage of about 10% - 90%, preferably 20% - 80%, most preferably 30% -70%.

Several comparison tests are performed between using prior art cleaning solution and using the cleaning (stripping) solution of the present invention.

### Test for removal rate of metal oxides

In this test, copper oxide is used as an example.

First, a square copper sheet is provided, with a copper oxide layer of a uniform thickness formed on the surface of the copper sheet. Immerse one half of the copper sheet in the tested cleaning solution and measure the required time (applied time) for complete removal of the copper oxide layer, thus obtaining the removal rate of copper oxide by the cleaning solution.

### Test for eroding effect on the metal

In this test, copper oxide is used as an example.

First, a square copper sheet is provided. Immerse one half of the copper sheet in the tested cleaning solution and measure the remained thickness of the copper sheet after a certain period.

### Residual test for organic residues and inorganic residues

A wafer is provided and patterned. Afterwards, the wafer is immersed in the tested cleaning solution. After a certain period, the wafer is taken out, rinsed with water and then dried. Later on, the scanning electron microscope (SEM) is used to observe whether any residues remain on the wafer.

### Test for corrosive effect on the low-k dielectric material layer

A wafer having a low-k dielectric material layer on the surface is provided and then immersed in the tested cleaning solution. After a certain period, the wafer is taken out, rinsed with water and then dried. Later on, the FT-IR spectrum of the low-k dielectric material layer on the wafer is taken to determine whether the low-k dielectric material layer is corroded.

### Preparation of the cleaning solution

Test sample: four weight units (units in weight) of propene-1,2,3-tricarboxylic acid is mixed with 65.6 weight units (units in weight) of water. Next, 0.4 weight units of mercaptosuccinic acid is added into the mixture. After mixing the solution well, 30 weight units of 1,3-dimethyl-2-imidazolidinone is added and the test sample of the cleaning solution of the present invention is obtained.

Comparative 1: having a composition as proposed in US Patent No. 6,156,661, including 55% diglycolamine, 10% gallic acid, 30% hydroxyl amine and 5% water.

Comparative 2: having a composition as proposed in US Patent No. 5,905,063, including 2% fluoric acid (HF), 88% DMSO and 10% water.

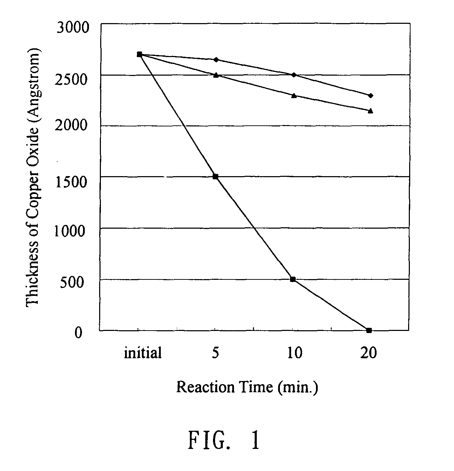

The above three cleaning solutions are tested for the capability of removing metal oxide and the results are shown in Fig. 1, while the symbols "■" "◆" "▲" represent respectively the test sample, comparative 1 and comparative 2. From Fig. 1, if the cleaning solution of the test sample is used, it can completely remove copper oxide (metal oxides) in about 20 minutes. On the contrary, compared with the test sample, the cleaning solution of comparative 1 merely removes 1/6 of the thickness of the copper oxide and the cleaning solution of comparative 2 removes half the thickness of the copper oxide during the same period. Therefore, the cleaning solution of the present invention has a superior capability of removing the metal oxide, when compared with the prior cleaning solutions. The cleaning solution of the present invention has excellent capability of removing metal oxides.

The cleaning solution of this invention (for example, test sample) is tested for the eroding effect on the metal and the results are shown in Table 1.

**Table 1**

| METAL | ERODING RATE |
|---|---|
| Cu | 1 A°/min |
| Al/0.5%Cu | 1 A°/min |
| Ti | 0 A°/min |
| W | 0 A°/min |
| TiW | 0 A°/min |
| Ta | 0 A°/min |

From Table 1, the cleaning (stripping) solution of the present invention can hardly erode the tested metal. Therefore, the cleaning (stripping) solution of the present invention can remove the metal oxide on the metal surface without damaging the underlying metal.

The cleaning solution of this invention (for example, test sample) is tested for the corrosive effect on the dielectric material layer and the results are shown in Table 2.

**Table 2**

| DIELECTIC LAYER | ERODING RATE |
|---|---|
| TEOS | 0 A°/min |
| BPSG | 0 A°/min |
| thermal oxide | 0 A°/min |
| FSG | 0 A°/min |
| black diamond | 0 A°/min |
| HSQ | 0 A°/min |

From Table 2, the cleaning solution of the present invention can hardly cause corrosion to the tested dielectric material layers. Therefore, the cleaning solution of the present invention can remove the residues on the surface of the dielectric material layer but without damaging the underlying dielectric material layer.

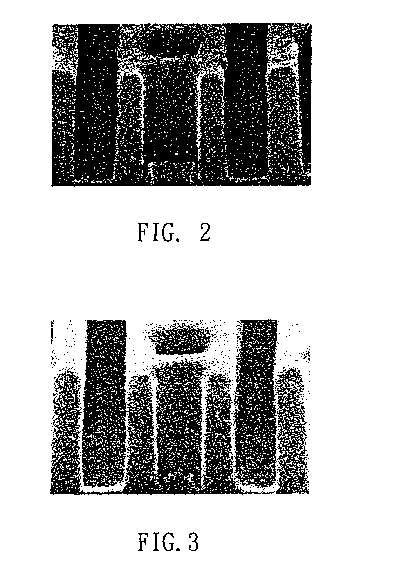

The cleaning solution of this invention (for example, test sample) is further tested for its effect on removing the organic and inorganic residues and the results are shown in Fig. 3. A wafer with organic and inorganic residues on the surface (as shown in Fig. 2) is provided, for comparison. After rinsing the wafer with the cleaning (stripping) solution of the present invention (such as, the test sample) to remove the residues, the rinsed wafer is shown in Fig. 3. From the comparison of Figs. 2 and 3, it clearly shows that the cleaning (stripping) solution of the present invention can completely remove the organic and inorganic residues remained on the surface of the wafer.

In conclusion, the cleaning solution of the present invention can effectively remove the metal oxides without damaging the metal surface at the same time. Moreover, the cleaning solution of the present invention can effectively remove the organic and inorganic residues simultaneously and prevent the low-k dielectric material layer from being damaged.

Therefore, the cleaning solution of this invention can effectively remove the metal oxides by using the first compound.

In addition, the cleaning solution of the present invention is not erosive toward the metal materials, thus effectively removing the metal oxides without damaging the metal surface at the same time.

Moreover, using the first compound in combination of the water-soluble solvent, the cleaning solution of this invention can effectively remove both the organic and inorganic residues.

Furthermore, the cleaning solution of the present invention is not corrosive toward the low-k dielectric materials, thus preventing the low-k dielectric materials from being damaged.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A cleaning solution, comprising a mixture of a first compound, a second compound and water.

2. The cleaning solution of claim 1, wherein the first compound is selected from the following group consisting of oxalic acid, malonic acid, tartaric acid, propene-1,2,3-tricarboxylic acid, sulfosuccinic acid, oxalacetic acid, methylenesuccinic acid, succinic acid, citramalic acid and malic acid.

3. The cleaning solution of claim 1, wherein the first compound has a weight percentage of about 1% - 20%, preferably about 2% -15% and most preferably about 3% -8%.

4. The cleaning solution of claim 1, wherein the second compound is selected from the following group consisting of citric acid, glyoxylic acid, lactic acid, mercaptosuccinic acid, fumaric acid, acetylenedicarboxylic acid and methacrylic acid.

5. The cleaning solution of claim 1, wherein the second compound has a weight percentage of about 0.01% - 20%, preferably about 0.1% -10% and most preferably about 0.15%-1.0%.

6. The cleaning solution of claim 1, further comprising a water-soluble solvent, wherein the water-soluble solvent is selected from the following group consisting of γ-butyrolactone, N-methyl-2-pyrrolidone, propylene glycol methyl ether (PGME), dimethylsulfoxide (DMSO), teramethylenesulfone, 1,3-dimethyl-2-imidazolidinone, 1,3-diethyl-imidazolidinone, ethylene glycol, ethylene glycol monoethyl ether, ethylene glycol monobutyl ether, N,N-dimethylformamide and N,N-dimethylacetamide.

7. The cleaning solution of claim 6, wherein the water-soluble solvent has a weight percentage of about 10% - 90%, preferably about 20% - 80% and most preferably about 30% -70%.

8. The cleaning solution of claim 1, further comprising a surfactant, wherein the surfactant comprises a nonyl phenol polyethylene glycol ether.

9. The solution of claim 1, further comprising a suppressor, wherein the suppressor is selected from the following group consisting of 1,2,3-benzotriazole, benzoinoxime, salicylasldoxime, bis [4-amino-5-hydroxy-1,2,3-triazol-3-yl] methane and bis [4-amino-5-hydroxy-1,2,4-triazol-3-yl] butane.
